# FASCICULE DE BREVET EUROPEEN

(11) **EP 2 697 899 B1**
(45) Date de publication et mention de la délivrance du brevet: **10.06.2015**
(21) Numéro de dépôt: 12720787.6
(22) Date de dépôt: 12.04.2012
(51) Int. Cl.: H02M 3/156, H03K 7/06, H04B 15/06, H05B 33/08

(54) **SYSTEME D'ETALEMENT DE SPECTRE LIE A L'USAGE D'UN REGULATEUR A DECOUPAGE UTILISE DANS UN COMBINE OU AFFICHEUR DE TABLEAU DE BORD DE VEHICULE AUTOMOBILE**
SYSTEM ZUM STREUEN EINES SPEKTRUMS, DAS VON DER BENUTZUNG EINES SCHALTREGLERS IN EINEM EMPFÄNGER ODER IN DER ANZEIGETAFEL DER ARMATUR EINES FAHRZEUGS HERRÜHRT.
SYSTEM FOR SPREADING A SPECTRUM LINKED TO THE USAGE OF A SWITCHING REGULATOR USED IN A RECEIVER OR DISPLAY OF A DASHBOARD OF AN AUTOMOBILE

(30) Priorité: 13.04.2011 DE 102011016919; 08.06.2011 FR 1101755
(43) Date de publication de la demande: 19.02.2014
(73) Titulaire: Johnson Controls Automotive Electronics SAS, 95892 Cergy-Pontoise Cedex (FR)
(72) Inventeur: CIRJEAN, Jean-Paul, F-95610 Eragny sur Oise (FR)
(74) Mandataire: Schwöbel, Thilo K.
(86) Numéro de dépôt international: PCT/EP2012/001579
(87) Numéro de publication internationale: WO 2012/139754

(56) Documents cités:
- EP-A2- 1 592 154
- CN-U- 201 557 091
- US-A- 4 188 585
- US-A1- 2009 174 338
- Texas Instruments Incorporated: "Economy Primary Side Controller", , 1 novembre 1999 (1999-11-01), pages 1-8, XP002683529, Extrait de l'Internet: URL:http://www.ti.com/lit/ds/symlink/ucc28 09-1.pdf [extrait le 2012-09-14]
- Texas Instruments Incorporated: "4.5-V TO 52-V INPUT CURRENT MODE BOOST CONTROLLER", , 1 mars 2008 (2008-03-01), pages 1-19, XP002683530, Extrait de l'Internet: URL:http://www.ti.com/product/tps40210 [extrait le 2012-09-14]

## Description

La présente invention concerne un système d'étalement de spectre lié à l'usage d'un régulateur à découpage utilisé dans un combiné ou un afficheur de tableau de bord de véhicule automobile. Ce système, composé d'un arrangement de composants électroniques, est connecté à un régulateur à découpage.

Dans l'état de la technique, des régulateurs à découpage (aussi appelés convertisseurs à découpage ou convertisseurs DC-DC, en anglais : "switching regulator", "switching converter" ou "DC-DC converter") sont connus pour fournir une certaine tension ou un certain courant à un ou plusieurs éléments électroniques. Le régulateur à découpage comprend au moins un dispositif de stockage d'énergie, comme par exemple une inductance, et au moins un commutateur commutable périodiquement, qui est typiquement réalisé par l'intermédiaire d'un transistor ou de plusieurs transistors. Typiquement, un oscillateur fournit une fréquence de commutation au régulateur à découpage, cette fréquence de commutation étant normalement de l'ordre de grandeur de plusieurs centaines de kHz, c'est à dire dans le domaine des hautes fréquences (ou radio fréquences).

La fréquence de commutation élevée peut conduire à la génération de bruits hautes fréquences à l'intérieur de la source de tension et à l'émission d'ondes électromagnétiques qui peuvent interférer avec d'autres composants ou éléments électroniques voisins, et, par conséquent, mener à un mauvais fonctionnement de tels composants ou éléments électroniques voisins. Notamment, des transmissions par des ondes électromagnétiques (notamment dans le domaine des radio fréquences) peuvent être perturbés.

Par conséquent et de règle générale, des composants ou éléments électroniques doivent être conforme à des exigences élevées, notamment prescrites par des autorités publiques, qui définissent des valeurs limites concernant l'émission d'ondes électromagnétiques.

Dans l'état de la technique par exemple EP 1592154 et US 4188585, des filtres de fréquence sont connus qui sont susceptibles d'éliminer (ou supprimer) les parties hautes fréquences d'un signal, notamment pour réduire l'émission d'ondes électromagnétiques parasites.

La présente invention à notamment pour but de palier aux inconvénients de l'art connu, et notamment à ceux cités ci-dessus, et a également pour but de proposer un arrangement de composants électroniques amélioré, l'arrangement de composants électroniques étant destiné pour l'usage avec un régulateur à découpage, pour ainsi réduire les effets négatifs engendrés par les émissions d'ondes électromagnétiques parasites sur les composants ou éléments électroniques.

Suivant l'invention, selon la revendication 1, ce but est atteint par un arrangement de composants électroniques pour l'usage avec un régulateur à découpage, notamment pour une utilisation dans un tableau de bord d'un véhicule automobile,
le régulateur à découpage comprenant un premier oscillateur ayant une première fréquence, l'arrangement de composants électroniques étant prévu pour être lié à une source de tension, la source de tension fournissant une tension périodique ayant une deuxième fréquence, la deuxième fréquence étant inférieure à la première fréquence, l'arrangement de composants électroniques étant composé d'une première résistance, d'une première capacité, d'une deuxième résistance, d'une deuxième capacité pour éliminer une composante continue, d'une troisième résistance ainsi qu'une troisième capacité et une quatrième capacité, la quatrième capacité étant prévue en parallèle avec la troisième capacité. Ces deux capacités ne faisant qu'une pour fixer la première fréquence du régulateur à découpage et génère des fluctuations autour de la première fréquence.

De par une telle réalisation de l'arrangement de composants électroniques, il est avantageusement possible de réaliser des modulations ou des fluctuations de la fréquence de commutation, c'est à dire la première fréquence.

De telles fluctuations de la fréquence de commutation ou première fréquence provoquent un étalement ou élargissement spectrale des ondes électromagnétiques émises de telle manière que l'énergie émise soit répartie sur une plage spectrale plus large, et, par conséquent, les amplitudes maximales de telles ondes électromagnétiques sur la plage spectrale concernée sont réduites par rapport à une situation sans fluctuations. Il s'ensuit que des effets d'interférence et notamment le couplage des ondes (ou radiations) électromagnétiques émises à d'autres composants ou éléments électroniques peut être réduit.

Un élément de l'invention réside dans le fait que la tension périodique de la source de tension est fournie
- par un microprocesseur et/ou
- par un circuit programmable (en anglais: FPGA (Field Programmable Gate Array) et/ou
- par un circuit logique (en anglais: logic circuit).

De par une telle réalisation de l'arrangement de composants électroniques, il est avantageusement possible d'utiliser l'arrangement de composants électroniques selon la présente invention dans de situations diverses et notamment avec tous types de régulateur à découpage dont la fréquence est fixée de façon externe.

Selon encore un autre mode de réalisation préféré de l'invention, la première fréquence est comprise entre 100 kHz et 1 MHz, de préférence entre 200 kHz et 500 kHz, encore de préférence entre 300 kHz et 400 kHz, encore plus de préférence 350 kHz.

Selon un mode de réalisation préféré de l'arrangement de composants électroniques selon la présente invention, la deuxième fréquence est comprise entre 50 Hz et 10 kHz, de préférence entre 100 Hz et 5 kHz, encore de préférence entre 500 Hz et 2 kHz, , encore plus de préférence entre 900 Hz et 1.1 kHz.

De par la flexibilité d'une telle réalisation du dispositif, il est avantageusement possible de réaliser les fluctuations de la fréquence de commutation - la première fréquence - de manière simple et efficace, notamment avec des composants électroniques peu coûteux.

Selon un autre mode de réalisation préféré l'arrangement de composants électroniques selon la présente invention, la tension périodique est une tension périodique ayant un rapport cyclique (en anglais: duty cycle) entre 20% et 80%, de préférence entre 40% et 60%, notamment de 50%.

La présente invention concerne également un système, notamment pour une utilisation dans un combiné ou un afficheur de tableau de bord de véhicule automobile, comprenant
-- un régulateur à découpage,
-- un arrangement de composants électroniques pour l'usage avec le régulateur à découpage, et
-- une source de tension,
le régulateur à découpage comprenant un premier oscillateur ayant une première fréquence, l'arrangement de composants électroniques étant liée à la source de tension, la source de tension fournissant une tension périodique ayant une deuxième fréquence, la deuxième fréquence étant inférieure à la première fréquence,
l'arrangement de composants électroniques étant composé d'une première résistance, d'une première capacité, d'une deuxième résistance, d'une deuxième capacité pour éliminer une composante continue, d'une troisième résistance ainsi qu'une troisième capacité et et une quatrième capacité, la quatrième capacité étant prévue en parallèle avec la troisième capacité. Ces deux capacités ne faisant qu'une pour fixer la première fréquence du régulateur à découpage et génère des fluctuations autour de la première fréquence.

D'autres caractéristiques et avantages de l'invention ressortiront à la lecture de la description qui suit d'un mode de réalisation particulier non limitatif de l'invention.

### BREVE DESCRIPTION DES DESSINS

L'invention sera mieux comprise grâce à la description ci-après, qui se rapporte à des modes de réalisation préférés, donnés à titre d'exemples non limitatifs, et expliqués avec référence aux dessins schématiques annexés, dans lesquels :
la figure 1 est une vue schématique sur système selon la présente invention, comprenant un arrangement de composants électroniques ainsi qu'un régulateur à découpage,
la figure 2 est un diagramme de deux mesures conduites avec le régulateur à découpage, mais sans l'utilisation de l'arrangement de composants électroniques, et
la figure 3 est un diagramme de deux mesures conduites avec le régulateur à découpage et avec l'utilisation de l'arrangement de composants électroniques selon la présente invention.

### DESCRIPTION DES DESSINS

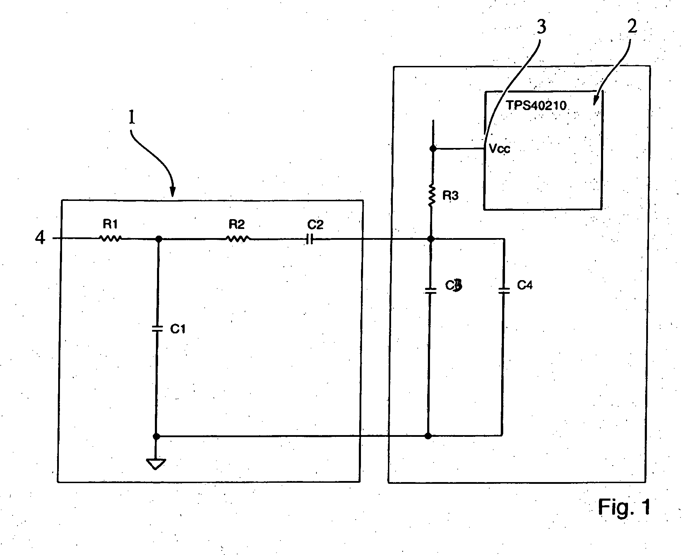

Dans la figure 1, une vue schématique du système selon la présente invention est représenté, comprenant un arrangement de composants électroniques 1 ainsi qu'un régulateur à découpage 2.

Il est préféré selon la présente invention que l'arrangement de composants électroniques 1 comporte au moins une première résistance et une première capacitance pour la génération d'un signal de commande (ou signal pilote), ayant une évolution, dans le temps, de la tension (du signal de commande) en forme de dent de scie.

La figure 1 montre un schéma fonctionnel de l'arrangement de composants électroniques 1 qui est représenté avec le régulateur à découpage 2. L'arrangement de composants électroniques 1 est monté en série avec le régulateur à découpage 2 (et positionné avant le régulateur à découpage 2).

Le régulateur à découpage 2 est, dans l'exemple représenté, un convertisseur pour augmenter la tension et/ou le courant (en anglais: "boost converter" ou "step-up regulator"), par exemple un circuit intégré TPS 40210 de la compagnie Texas Instruments. Le régulateur à découpage 2 comprend un premier oscillateur qui n'est pas représenté dans la figure 1. Le premier oscillateur fournit une fréquence de commutation (première fréquence) pour piloter un commutateur du régulateur à découpage 2. Le régulateur à découpage 2 fournit à sa sortie une tension de sortie U_{A} qui est plus élevée qu'une tension d'entrée (qui n'est pas représentée dans la figure 1) qui est fournie au régulateur à découpage 2 à une entrée.

Le régulateur à découpage 2 sert notamment pour l'alimentation électrique de composants ou éléments électriques ou électroniques, notamment un combiné ou un afficheur de tableau de bord de véhicule automobile.

Dans un exemple selon la présente invention, le régulateur à découpage 2 utilise une fréquence de 350 kHz ou d'environ 350 kHz en tant que première fréquence (c'est à dire fréquence de commutation). Le régulateur à découpage 2 est relié à l'arrangement de composants électroniques 1 selon la présente invention par l'intermédiaire d'une broche 3 (en anglais: pin).

Une source de tension 4 comprend un deuxième oscillateur et fournit un signal de commande pour générer des fluctuations destinées à faire varier la première fréquence (de commutation) du régulateur à découpage 2. Le signal de commande de la source de tension 4 a notamment une évolution (de la tension dans le temps) rectangulaire avec une deuxième fréquence qui inférieure à la première fréquence. La deuxième fréquence est par exemple de 50 Hz ou de 1 kHz et comprend un rapport cyclique (en anglais: "duty cycle") de (par exemple) 50%. Le deuxième oscillateur de la source de tension 4 peut être intégré ou réalisée dans un circuit de contrôle (en anglais: microcontroller) ou dans un circuit intégré avec un circuit logique.

Une première résistance R1 et une première capacitance C1 convertit la tension de la source de tension 4 (notamment une tension rectangulaire) dans une tension à évolution en forme de dents de scie. Dans l'exemple de réalisation montré dans la figure 1, la première résistance R1 est de 4,7 kΩ, et la première capacitance C1 est de 220 nF. Une deuxième capacitance C2 élimine la composante continue de tension dans le signal issue de la première résistance R1 et de la première capacitance C1. Dans l'exemple de réalisation montré dans la figure 1, la deuxième capacitance C2 est de 10 nF. La capacitance de la deuxième capacitance C2 est supérieure à la somme des capacitances d'une troisième capacitance C3 et d'une quatrième capacitance C4. Dans l'exemple de réalisation montré dans la figure 1, la troisième capacitance C3 est de 220 pF, et la quatrième capacitance C4 est de 22 pF.

Une deuxième résistance R2 limite la tension utilisée pour charger les troisième et quatrième capacitances C3, C4 (formant une capacité bis égale à C3 + C4 permettant de fixer la première fréquence plus précisément vers 350kHz). La troisième capacitance C3 ainsi que la quatrième capacitance C4 est relié par une troisième résistance R3 à la broche 3. Dans l'exemple de réalisation montré dans la figure 1, la troisième résistance R3 est de 200 kΩ. Avec l'arrangement de composants électroniques 1, des fluctuations d'environ 50 kHz sont réalisées autour de la première fréquence (de commutation) de 350 kHz.

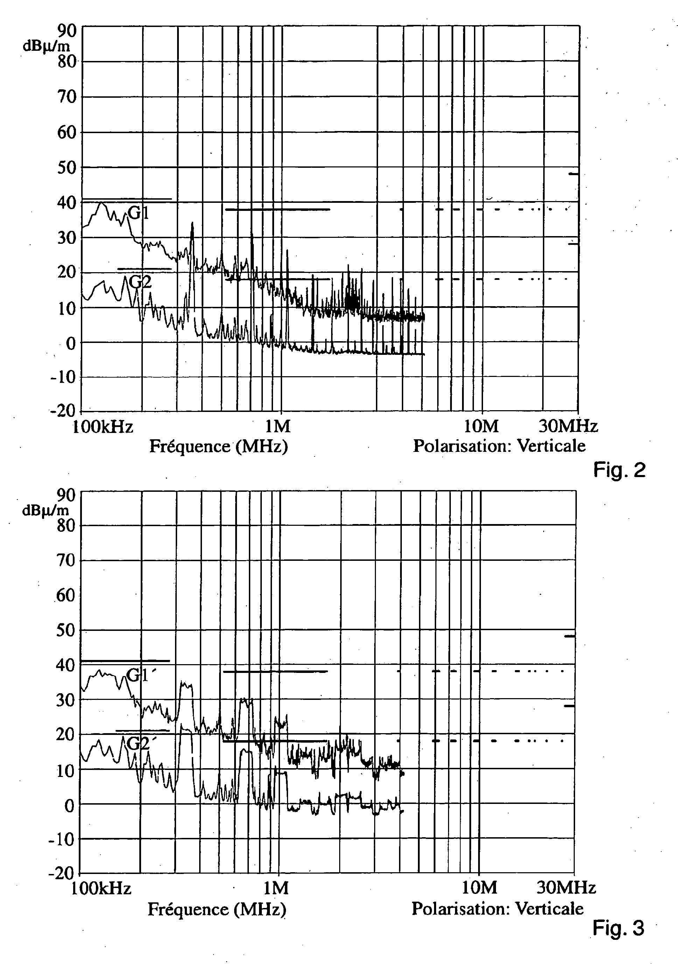

La figure 2 montre, pour deux situations différentes, un diagramme spectral des ondes électromagnétiques émises par le régulateur à découpage 2 dans la situation ou l'arrangement de composants électroniques 1 n'est pas présent ou actif. Les deux situations différentes sont représentés par les signes de référence G1 et G2 (qui correspondent à des paramètres d'entrée différents). Le diagramme montre des maximums locaux du champ électromagnétique émis à l'endroit de la première fréquence (de commutation) ainsi qu'aux multiples harmoniques de cette fréquence.

La figure 3 montre, pour deux situations différentes, un diagramme spectral des ondes électromagnétiques émises par le régulateur à découpage 2 dans la situation ou l'arrangement de composants électroniques 1 est présent et actif. L'arrangement de composants électroniques 1 génère des fluctuations autour de la première fréquence (de commutation) de 350 kHz. Les fluctuations s'étalent sur une plage d'environ 50 kHz. Les deux situations différentes sont représentés par les signes de référence G1' et G2' (qui correspondent à des paramètres d'entrée différents). Le diagramme montre une évolution du champ électromagnétique émis à l'endroit de la première fréquence (de commutation) (ainsi qu'aux multiples harmoniques de cette fréquence) qui est plus large, et, par conséquent, ayant un champ électromagnétique émis réduit (d'environ 15 dB par rapport aux maximums des courbes G1 et G2).

Un tel régulateur à découpage 2 est notamment utilisé dans un dans un combiné de tableau de bord de véhicule automobile, par exemple pour contrôler des LEDs ou d'autres composants électriques ou électroniques.

## Revendications

1. Arrangement de composants électroniques (1) pour l'usage avec un régulateur à découpage (2), notamment pour une utilisation dans un combiné ou afficheur de tableau de bord de véhicule automobile,
le régulateur à découpage (2) comprenant un premier oscillateur ayant une première fréquence,
l'arrangement de composants électroniques (1) étant prévu pour être lié à une source de tension (4), la source de tension (4) fournissant une tension périodique ayant une deuxième fréquence, la deuxième fréquence étant inférieure à la première fréquence,
l'arrangement de composants électroniques (1) étant composé d'une première résistance (R1), d'une première capacité (C1), d'une deuxième résistance (R2), d'une deuxième capacité (C2) pour éliminer une composante continue, d'une troisième résistance (R3) ainsi qu'une troisième capacité (C3), **caractérisé en ce que** l'
arrangement de composants électroniques (1) comprend une quatrième capacité (C4), la quatrième capacité étant prévue en parallèle avec la troisième capacité (C3) pour fixer la première fréquence du régulateur à découpage et génère des fluctuations autour de la première fréquence.

2. Arrangement de composants électroniques (1) selon la revendication 1, **caractérisé en ce que** la tension périodique de la source de tension (4) est fournie
-- par un microprocesseur et/ou
-- par un circuit programmable (en anglais: FPGA (Field Programmable Gate Array)) et/ou
-- par un circuit logique (en anglais: logic circuit).

3. Arrangement de composants électroniques (1) selon l'une quelconque des revendications précédentes, **caractérisé en ce que** la première fréquence est comprise entre 100 kHz et 1 MHz, de préférence entre 200 kHz et 500 kHz, encore de préférence entre 300 kHz et 400 kHz, encore plus de préférence 350 kHz.

4. Arrangement de composants électroniques (1) selon l'une quelconque des revendications précédentes, **caractérisé en ce que** la deuxième fréquence est comprise entre 50 Hz et 10 kHz, de préférence entre 100 Hz et 5 kHz, encore de préférence entre 500 Hz et 2 kHz, encore plus de préférence entre 900 Hz et 1.1 kHz.

5. Arrangement de composants électroniques (1) selon l'une quelconque des revendications précédentes, **caractérisé en ce que** la tension périodique est une tension périodique ayant un rapport cyclique (en anglais: duty cycle) entre 20% et 80%, de préférence entre 40% et 60%, notamment de 50%.

6. Système, notamment pour une utilisation dans un combiné ou afficheur de tableau de bord de véhicule automobile, comprenant
-- un régulateur à découpage (2),
-- un arrangement de composants électroniques (1) selon la revendication 1 pour l'usage avec le régulateur à découpage (2), et
-- une source de tension (4),
le régulateur à découpage (2) comprenant un premier oscillateur ayant une première fréquence,
l'arrangement de composants électroniques (1) étant liée à la source de tension (4), la source de tension (4) fournissant une tension périodique ayant une deuxième fréquence, la deuxième fréquence étant inférieure à la première fréquence,
l'arrangement de composants électroniques (1) étant composé d'une première résistance (R1), d'une première capacité (C1), d'une deuxième résistance (R2), d'une deuxième capacité (C2) pour éliminer une composante continue, d'une troisième résistance (R3) ainsi qu'une troisième capacité (C3), **caractérisé en ce que** l'arrangement de composants électroniques (1) comprend une quatrième capacité (C4), la quatrième capacité étant prévue en parallèle avec la troisième capacité (C3) pour fixer la première fréquence du régulateur à découpage et génère des fluctuations autour de la première fréquence.

## Patentansprüche

1. Anordnung von elektronischen Komponenten (1) zur Benutzung mit einem Schaltregler (2), insbesondere für eine Benutzung in einem Empfänger oder einer Anzeigeeinrichtung eines Kraftfahrzeug-Armaturenbretts,
wobei der Schaltregler (2) einen ersten Oszillator aufweist, der eine erste Frequenz hat, wobei die Anordnung von elektronischen Komponenten (1) vorgesehen ist, um mit einer Spannungsquelle (4) verbunden zu werden, wobei die Spannungsquelle (4) eine periodische Spannung liefert, die eine zweite Frequenz hat, wobei die zweite Frequenz niedriger als die erste Frequenz ist,
wobei sich die Anordnung von elektronischen Komponenten (1) aus einem ersten Widerstand (R1), einer ersten Kapazität (C1), einem zweiten Widerstand (R2), einer zweiten Kapazität (C2) zum Eliminieren eines Gleichstromanteils, einem dritten Widerstand (R3) sowie einer dritten Kapazität (C3) zusammensetzt, **dadurch gekennzeichnet, dass** die Anordnung von elektronischen Komponenten (1) eine vierte Kapazität (C4) aufweist, wobei die vierte Kapazität parallel zu der dritten Kapazität (C3) vorgesehen ist, um die erste Frequenz des Schaltreglers zu fixieren und Schwankungen um die erste Frequenz erzeugt.

2. Anordnung von elektronischen Komponenten (1) nach Anspruch 1, **dadurch gekennzeichnet, dass** die periodische Spannung der Spannungsquelle (4) geliefert wird von
- einem Mikroprozessor und/oder
- einer programmierbaren Schaltung (in englischer Sprache: FPGA (Field Programmable Gate Array)) und/oder
- durch eine Logikschaltung (in englischer Sprache: logic circuit).

3. Anordnung von elektronischen Komponenten (1) nach einem der vorhergehenden Ansprüche, **dadurch gekennzeichnet, dass** die erste Frequenz zwischen 100 kHz und 1 MHz liegt, vorzugsweise zwischen 200 kHz und 500 kHz, noch bevorzugter zwischen 300 kHz und 400 kHz und noch bevorzugter 350 kHz beträgt.

4. Anordnung von elektronischen Komponenten (1) nach einem der vorhergehenden Ansprüche, **dadurch gekennzeichnet, dass** die zweite Frequenz zwischen 50 Hz und 10 kHz, vorzugsweise zwischen 100 Hz und 5 kHz, noch bevorzugter zwischen 500 Hz und 2 kHz und noch bevorzugter zwischen 900 Hz und 1,1 kHz liegt.

5. Anordnung von elektronischen Komponenten (1) nach einem der vorhergehenden Ansprüche, **dadurch gekennzeichnet, dass** die periodische Spannung eine periodische Spannung ist, die ein Tastverhältnis (in englischer Sprache: duty cycle) zwischen 20 % und 80 %, vorzugsweise zwischen 40 % und 60 %, insbesondere 50 % hat.

6. System, insbesondere für eine Benutzung in einem Empfänger oder einer Anzeigeeinrichtung eines Kraftfahrzeug-Armaturenbretts, das
- einen Schaltregler (2),
- eine Anordnung von elektronischen Komponenten (1) nach Anspruch 1 zur Benutzung mit dem Schaltregler (2) und
- eine Spannungsquelle (4),
aufweist, wobei der Schaltregler (2) einen ersten Oszillator aufweist, der eine erste Frequenz hat,
wobei die Anordnung von elektronischen Komponenten (1) mit der Spannungsquelle (4) verbunden ist, wobei die Spannungsquelle (4) eine periodische Spannung liefert, die eine zweite Frequenz hat, wobei die zweite Frequenz niedriger als die erste Frequenz ist, wobei sich die Anordnung von elektronischen Komponenten (1) aus einem ersten Widerstand (R1), einer ersten Kapazität (C1), einem zweiten Widerstand (R2), einer zweiten Kapazität (C2) zum Eliminieren eines Gleichstromanteils, einem dritten Widerstand (R3) sowie einer dritten Kapazität (C3) zusammensetzt, **dadurch gekennzeichnet, dass** die Anordnung von elektronischen Komponenten (1) eine vierte Kapazität (C4) aufweist, wobei die vierte Kapazität parallel zu der dritten Kapazität (C3) vorgesehen ist, um die erste Frequenz des Schaltreglers zu fixieren und Schwankungen um die erste Frequenz erzeugt.

## Claims

1. Arrangement of electronic components (1) for use with a switching regulator (2), in particular for an application in an instrument cluster or display of the dashboard of a motor vehicle,
the switching regulator (2) comprising a first oscillator having a first frequency, the arrangement of electronic components (1) being intended to be connected to a voltage source (4) wherein said voltage source (4) supplies a periodic voltage having a second frequency wherein said second frequency is lower than said first frequency, and
wherein the arrangement of electronic components (1) comprises a first resistance (R1), a first capacitor (C1), a second resistance (R2), a second capacitor (C2) to eliminate a DC component, a third resistance (R3), as well as a third capacitor (C3), **characterised in that**
the arrangement of electronic components (1) comprises a fourth capacitor (C4) wherein said fourth capacitor is arranged in parallel with the third capacitor (C3) to fix the first frequency of the switching regulator and to generate fluctuations around the first frequency.

2. Arrangement of electronic components (1) according to claim 1, **characterised in that** the periodic voltage of the voltage source (4) is supplied
-- by a microprocessor and/or
-- by a programmable circuit (FPGA: Field Programmable Gate Array) and/or
-- by a logic circuit.

3. Arrangement of electronic components (1) according any one of the preceding claims, **characterised in that** the first frequency comprises between 100 kHz and 1 MHz, preferably between 200 kHz and 500 kHz, particularly preferably between 300 kHz and 400 kHz, even more preferably 350 kHz.

4. Arrangement of electronic components (1) according to any one of the preceding claims **characterised in that** the second frequency comprises between 50 Hz and 10 kHz, preferably between 100 Hz and 5 kHz, particularly preferably between 500 Hz and 2 kHz, even more preferably between 900 Hz and 1.1 kHz.

5. Arrangement of electronic components (1) according to any one of the preceding claims **characterised in that** the periodic voltage is a periodic voltage having a duty cycle between 20% and 80%, preferably between 40% and 60%, and particularly 50%.

6. System, in particular for an application in an instrument cluster or display of the dashboard of a motor vehicle, comprising
-- a switching regulator (2),
-- an arrangement of electronic components (1) according to claim 1 for use with a switching regulator (2), and
-- a voltage source (4),
the switching regulator (2) comprising a first oscillator having a first frequency, the arrangement of electronic components (1) being connected to the voltage source (4) wherein said voltage source (4) supplies a periodic voltage having a second frequency wherein said second frequency is lower than said first frequency, and
wherein the arrangement of electronic components (1) comprises a first resistance (R1), a first capacitor (C1), a second resistance (R2), a second capacitor (C2) to eliminate a DC component, a third resistance (R3), as well as a third capacitor (C3), **characterised in that** the arrangement of electronic components (1) comprises a fourth capacitor (C4) wherein said fourth capacitor is arranged in parallel with the third capacitor (C3) to fix the first frequency of the switching regulator and to generate fluctuations around the first frequency.
